# EUROPEAN PATENT SPECIFICATION

(11) **EP 2 920 820 B1**
(45) Date of publication and mention of the grant of the patent: **11.07.2018**
(21) Application number: 13801888.2
(22) Date of filing: 14.11.2013
(51) Int. Cl.: H01L 31/048, H01L 31/05, H01L 31/18

(54) **BACK-CONTACTED SOLAR PANEL AND METHOD FOR MANUFACTURING SUCH A SOLAR PANEL**
SOLARPANEEL MIT RÜCKSEITENKONTAKT UND VERFAHREN ZUR HERSTELLUNG SOLCH EINES SOLARPANEELS
PANNEAU SOLAIRE À CONTACTS ARRIÈRE ET PROCÉDÉ DE FABRICATION D'UN TEL PANNEAU SOLAIRE

(30) Priority: 19.11.2012 NL 2009836
(43) Date of publication of application: 23.09.2015
(73) Proprietor: Stichting Energieonderzoek Centrum Nederland, 1755 LE Petten (NL)
(72) Inventor: BULTMAN, Jan Hendrik, NL-1755 LE Petten (NL); DE JONG, Paulus Cornelis, NL-1755 LE Petten (NL); BENNETT, Ian John, NL-1755 LE Petten (NL); BROEK, Kornelis Marinus, NL-1755 LE Petten (NL); KLOOS, Marius, NL-1755 LE Petten (NL); SPÄTH, Martin, NL-1722 GD Zuid-Scharwoude (NL)
(74) Representative: Nederlandsch Octrooibureau
(86) International application number: PCT/NL2013/050819
(87) International publication number: WO 2014/077686

(56) References cited:
- WO-A1-2011/071373
- WO-A2-2010/027265
- US-A1- 2008 236 655
- DE JONG P C ET AL: "SINGLE-STEP LAMINATED FULL-SIZE PV MODULES MADE WITH BACK-CONTACTED MC-SI CELLS AND CONDUCTIVE ADHESIVES", 19th European Photovoltaic Solar Energy Conference, Paris 7-11 June 2004 INTERNET CITATION, vol. II 7 June 2004 (2004-06-07), pages 2145-2148, XP002677159, Retrieved from the Internet: URL:ftp://ftp.ecn.nl/pub/www/library/repor t/2004/rx04067.pdf [retrieved on 2012-06-05] cited in the application
- SPÄTH M ET AL: "First experiments on module assembly line using back-contact solar cells", 23RD EUROPEAN PHOTOVOLTAIC SOLAR ENERGY CONFERENCE, EU PVSEC ; PROCEEDINGS OF THE INTERNATIONAL CONFERENCE, HELD IN VALENCIA, SPAIN, 1 - 5 SEPTEMBER 2008, WIP-RENEWABLE ENERGIES, 1 September 2008 (2008-09-01), pages 2917-2921, XP007919747, DOI: 10.4229/23RDEUPVSEC2008-4AV.3.47 ISBN: 978-3-936338-24-9 cited in the application
- J. H. BULTMAN ET AL.: "Fast and easy single step module assembly for back-contacted c-Si solar cells with conductive adhesives", WCPEC-3, PROCEEDINGS OF THE 3RD WORLD CONFERENCE ON PHOTOVOLTAIC ENERGY CONVERSION,, 11 May 2003 (2003-05-11), - 18 May 2003 (2003-05-18), pages 979-982, XP040509786, OSAKA,JP
- MEUWISSEN M. ET AL.: "Simulation assisted design of a PV module incorporating electrically conductive adhesive interconnects", 21ST EUROPEAN PHOTOVOLTAIC SOLAR ENERGY CONFERENCE : PROCEEDINGS OF THE INTERNATIONAL CONFERENCE HELD IN DRESDEN, GERMANY, 4 - 8 SEPTEMBER 2006, WIP RENEWABLE ENERGIES, MÜNCHEN, 4 September 2006 (2006-09-04), - 8 September 2006 (2006-09-08), pages 2485-2490, XP040512698, ISBN: 978-3-936338-20-1

## Description

### Field of the invention

The present invention relates to a solar panel and to a method for manufacturing such a solar panel.

### Prior art

Back-contacted solar panels or photovoltaic (PV) modules are well known in the art.

Within the solar panel an array of back-contacted solar cells is arranged. Back-contacted cells are typically interconnected using either short tabs attached to bus-bars at the edges of the rear of the cell or using a conductive back-sheet foil.

The former method of using short tabs involves soldering the tabs to the contact points on the cell. This results in local residual stress on one side of the cell. This is seen in bowing and in some cases cracking of the cells. During lamination, the cells are flattened so increasing the chance of damage and power loss. Cracks will also grow during the operation of the module further reducing power output.

The latter method of using a conductive back-sheet foil relates to a module technology based on a patterned conductive back-sheet foil for this type of cell. The pattern on the foil matches the contact points on the cell resulting in a series connection of the cells in the module. Interconnection between the cell and the foil can be done using solder or another type of conductive paste. Soldered modules are typically manufactured by using in-laminate soldering which involves the use of local heating of solder bumps by laser. Modules of this type typically show good performance in damp-heat, but poorer performance in thermal cycling showing that the adhesion strength between the solder, the cell and foil were insufficient.

"Single-step laminated full-size PV modules made with back-contacted MC-Si cells and conductive adhesives" by P.C. de Jong et al., 19th European Photovoltaic Solar Energy Conference, Paris 7-11 June 2004 , pp. 2145-2148, discloses a method for creating solar panel modules with back contacted PV cells using electrically conductive adhesives using a back-sheet foil that has been modified into an interconnection foil.

The method is arranged such that the mechanical strength of the adhesive is large enough to handle the mechanical shear stresses seen at the interconnection joints during temperature cycling and withstand tearing of the adhesive due to the shear stresses. It is observed that "bad" connections are formed due to too fast curing of the encapsulant layer.

"First experiments on module assembly line using back-contact solar cells" by M. Späth et al., 23rd European Photovoltaic Solar Energy Conference, 1-5 September 2008, Valencia, Spain, pp. 2917-2921, discloses a method for creating solar panel modules with "ultra -thin" (130µm) back contacted PV cells by using interconnecting adhesives instead of soldered contacts to overcome large shear stresses at the interface between solar cell and interconnecting body and/or the interface between back sheet and interconnecting body.

### Summary of the invention

It is an object of the present invention to provide a solar panel which overcomes the disadvantages from the prior art.

Additionally, it is an object of the invention to provide a method for manufacturing such a solar panel.

The object is achieved by a solar panel provided with a stack comprising at least one solar cell, a first encapsulant layer and a back-sheet contact layer; the at least one solar cell being arranged as a back contacted solar cell with a front surface for receiving radiation and a rear surface provided with electrical contacts; the back contact sheet layer having a surface provided with a patterned conductor circuit, the conductor circuit being arranged with contacting areas located at locations corresponding to locations of the electrical contacts on the at least one solar cell; the first encapsulant layer being provided with a pattern of openings at locations corresponding to the locations of the electrical contacts on the at least one solar cell; the at least one solar cell being arranged on top of the first encapsulant layer; the first encapsulant layer being arranged on top of the back-sheet contact layer, with the rear surface of the at least one solar cell facing the patterned conductor circuit surface, such that the first encapsulant layer is between the at least one solar cell and the back-sheet contact layer; the locations of the electrical contacts, the openings in the first encapsulant layer and the contacting areas being aligned with each other; each electrical contact of the at least one solar cell being connected through a corresponding opening in the first encapsulant layer with a respective corresponding contacting area of the conductor circuit by an interconnecting body, the interconnecting body being arranged in the opening in the first encapsulant layer, wherein the interconnecting body in a cured state is compressed between the contacting area and the corresponding electrical contact in such a way that in a direction perpendicular to an interface of the solar cell and the first encapsulant layer, the interconnecting body is in a pre-stressed state of a compressive stress.

Advantageously, the difference in (thermal) shrinkage provides that at low temperature (say about room temperature or lower, for example at night or under cloudy skies) the interconnecting body is compressed between the contact area of the conductor circuit and the electrical contact of the solar cell. This results in a pre-stressed state of the interconnecting body that counteracts the expansion during the heating step of a thermal cycle, for example, during daytime exposure to sunlight. In this manner, the interconnection between the back-sheet contact layer and the solar cell contacts is strengthened.

According to an aspect of the invention, there is provided a solar panel as described above wherein the material of the interconnecting body has a smaller thermal shrinkage than a thermal shrinkage of a material of the first encapsulant layer during lamination in a temperature interval from an elevated lamination temperature to about room temperature. If the interconnecting body shows less thermal shrinkage than the first encapsulant layer material the first encapsulant layer will compress the interconnecting bodies in the openings of the first encapsulant layer.

According to an aspect of the invention, there is provided a solar panel as described above wherein a material of the interconnecting body has a smaller overall shrinkage than an overall shrinkage of a material of the first encapsulant layer during the lamination process.

If the interconnecting body shows less overall shrinkage than the first encapsulant layer material the first encapsulant layer will compress the interconnecting bodies in the openings of the first encapsulant layer.

According to an aspect of the invention, there is provided a solar panel as described above wherein the material of the interconnecting body has an effective thermal expansion coefficient smaller that the effective thermal expansion coefficient of the material of the first encapsulant layer in said temperature interval.

According to an aspect of the invention, there is provided a solar panel as described above wherein the material of the interconnecting body has a smaller thermal shrinkage than the thermal shrinkage of the material of the back-sheet contact layer in said temperature interval.

The back-sheet contact layer can thus produce additional compression on the interconnecting bodies.

According to an aspect of the invention, there is provided a solar panel as described above, wherein the thermal shrinkage is determined substantially perpendicular to the interface of the first encapsulant layer and the solar cell.

If the compressive stress is mainly directed perpendicular to the interface, the connection between the conductor circuit contacting area and the corresponding solar cell contact is improved.

According to an aspect of the invention, there is provided a solar panel as described above, wherein the material of the interconnecting body is a conductive adhesive.

Advantageously, this interconnecting body material can be easily applied on the conductor area contacting areas. Also, this type of material can be tuned to have appropriate curing characteristics and mechanical properties to obtain interconnecting bodies showing compressive stress after lamination process.

According to an aspect of the invention, there is provided a solar panel as described above, wherein the conductive adhesive is a composite with a matrix material based on a polymer selected from a group of epoxy, acrylate, and silicone, and comprising a conductive component.

According to an aspect of the invention, there is provided a solar panel as described above wherein the conductive adhesive comprises metal particles forming a conductive path as the conductive component.

The conductive adhesive may be mixed with metallic particles that form conductive paths in the interconnecting bodies.

According to an aspect of the invention, there is provided a solar panel as described above wherein the conductive adhesive comprises as the conductive component a conductive path(s) consisting of low temperature solder.

The conductive adhesive may be mixed with low temperature solder material that may flow and form a conductive path(s) in the interconnecting bodies

According to an aspect of the invention, there is provided a solar panel as described above, wherein the solar panel further comprises a second encapsulant layer and a glass plate; the second encapsulant layer being arranged on top of the front surface of the at least one solar cell, and the glass plate being on top of the second encapsulant layer, the second encapsulant layer thus being between the at least one solar cell and the glass plate.

According to an aspect of the invention, there is provided a solar panel as described above, wherein the first and/or second encapsulant layer comprises a polymer selected from a group comprising ethylene-vinyl-acetate, ionomers, (poly)silicone, thermoplastic urethane, and polyvinyl butyral.

Such polymers show good properties of flow and shrinkage during the lamination process.

According to an aspect of the invention, there is provided a solar panel as described above, wherein the at least one solar cell is a silicon based back-contacted solar cell.

According to an aspect of the invention, there is provided a solar panel as described above, wherein in the back-sheet contact layer bulges are observable at locations corresponding with the locations of the interconnecting bodies in the solar panel.

Moreover, the present invention provides a method for manufacturing a solar panel as described above, the method comprising the steps of:
-- providing one or more back contacted solar cells with a front surface for receiving radiation and a rear surface provided with electrical contacts as the at least one solar cell;
-- providing the back-sheet contact layer with a patterned conductor circuit on a surface thereof, the conductor circuit being arranged with contacting areas located at locations corresponding to locations of the electrical contacts on the at least one solar cell;
-- providing at each contacting area an interconnecting body;
-- providing the first encapsulant layer with a pattern of openings at locations corresponding to the locations of the electrical contacts on the at least one solar cell;
-- arranging the patterned first encapsulant layer on top of the back-sheet contact layer, the pattern of openings being aligned with the locations of the electrical contacts in such a way that each interconnecting body is located in the corresponding opening in the first encapsulant layer;
-- arranging the at least one solar cell on top of the patterned first encapsulant layer with the rear surface of the at least one solar cell facing the patterned conductor circuit surface, and each of the electrical contacts of the at least one solar cell faces the corresponding interconnection body through the first encapsulant layer;
-- connecting each electrical contact of the at least one solar cell with a respective corresponding contacting area of the conductor circuit by the corresponding interconnecting body in the respective corresponding opening in the first encapsulant layer;
-- creating during a lamination step a compressive stress in the interconnecting body in a direction perpendicular to an interface between the at least one solar cell and the first encapsulant layer,
wherein after the lamination process of the stack, in a direction perpendicular to an interface of the solar cell and the first encapsulant layer, the interconnecting body is in a pre-stressed state of a compressive stress.

According to an aspect of the invention, there is provided a method as described above, wherein the material of the interconnecting body has a smaller overall shrinkage than an overall shrinkage of the material of the first encapsulant layer during the lamination process.

According to an aspect of the invention, there is provided a method as described above, wherein the material of the interconnecting body has a smaller thermal shrinkage than a thermal shrinkage of a material of the first encapsulant layer during lamination in a temperature interval from an elevated lamination temperature to about room temperature.

According to an aspect of the invention, there is provided a method as described above, wherein each interconnecting body is formed as a dot on the corresponding contacting area of the conductor circuit by stencil printing preceding the step of arranging the patterned first encapsulant layer on top of the back-sheet contact layer.

According to an aspect of the invention, there is provided a method as described above, wherein the formation of the dot includes that the formed dot has a height substantially larger than a thickness of the patterned first encapsulant layer.

According to an aspect of the invention, there is provided a method as described above, wherein the at least one solar cell is arranged on the patterned first encapsulant layer after formation of the interconnecting body dots on the contacting areas of the conductor circuit.

According to an aspect of the invention, there is provided a method as described above, wherein the material of the interconnecting body is a conductive adhesive and said step of connecting each electrical contact of the at least one solar cell with a respective corresponding contacting area of the conductor circuit comprises a curing heat treatment of the interconnecting body dot to form the interconnecting body.

According to an aspect of the invention, there is provided a method as described above, further comprising:
-- providing a second encapsulant layer over the front surface of the at least one solar cell;
-- providing a glass plate over the second encapsulant layer;
-- laminating the stack comprising the back-sheet contact layer, the first encapsulant layer, the at least one solar cell, the second encapsulant layer and the glass plate by exposure to an elevated temperature and an elevated pressure to form the solar panel.

According to an aspect of the invention, there is provided a method as described above, wherein the curing heat treatment of the interconnecting body dots takes place during said lamination step.

According to an aspect of the invention, there is provided a method as described above, wherein before said lamination step the first encapsulant layer has a thickness smaller than a height of the interconnection body.

The invention will be explained in more detail below with reference to drawings in which illustrative embodiments of the invention are shown. The drawings are intended for illustration purposes only without limitation of the scope of protection which is defined by the subject matter of the appended claims.

### Brief description of drawings

Figure 1a shows schematically a layout of a rear surface of back-contacted solar cells for application in a back contact solar panel;
Figure 1b shows schematically a layout of a conductor circuit on a back-sheet contact layer corresponding with the layout of contacts of the back-contacted solar cells of Figure 1a;
Figure 2 shows a cross-section of the back-contacted solar panel during a first manufacturing step;
Figure 3 shows a cross-section of the back-contacted solar panel during a subsequent manufacturing step;
Figure 4 shows a cross-section of the back-contacted solar panel during a next manufacturing step;
Figure 5 shows a cross-section of the back-contacted solar panel during yet a further manufacturing step according to an embodiment of the invention;
Figure 6 shows a cross-section of the back-contacted solar panel according to an embodiment of the invention;
Figure 7 shows a detail of the cross-section of a solar panel according to the invention.

### Description of embodiments

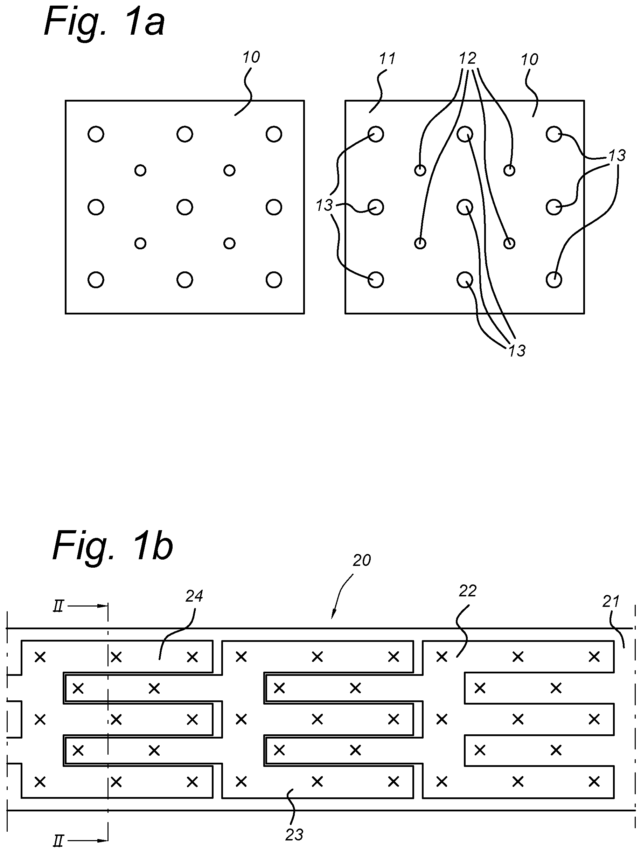

Figure 1a shows schematically a layout of a rear surface of back-contacted solar cells for application in a back contact solar panel.

Solar cells are typically provided with a pattern of conductive lines to carry electric charge that is generated by the photovoltaic effect in the solar cell. Various types of solid state solar cells are available, based on substrates of various semiconductor materials, for example, poly- or monocrystalline silicon.

In back-contacted solar cells the contacts of the conductor pattern are arranged on a rear surface of the solar cell, so as to minimize shadow losses on the front surface of the solar cell that faces in use a radiation source for example the Sun.

In figure 1a, a layout of an array of two back-contacted solar cells, adjacent to each other is shown. On each solar cell 10, a plurality of contacts of both polarities 12, 13 (e.g., positive contacts 12 and negative contacts 13) is arranged on the rear surface 11 of the solar cell.

The solar cells may be of the MWT (metal-wrap-through), EWT (Emitter wrap-through), IBC (interdigitated back-contact) or other back-contact silicon substrate type, that comprise all contacts at the rear of the cell either by conductive vias through the silicon substrate to connect the front surface region with rear surface electrical contact(s) of the solar cell or by having both the p- and n-type junctions and electrical contact(s) at the rear of the solar cell.

Figure 1b shows schematically a layout of a conductor circuit on a back-sheet contact layer corresponding with the layout of electrical contacts of the back-contacted solar cells of Figure 1a.

The back-sheet contact layer 20 is typically a polymer based layer 21 provided with a patterned conductive layer, i.e., a conductor circuit comprising one or more patterned conductive areas 22, 23, 24. For example, the conductive areas may be interdigitated, but other pattern shapes and pattern arrangements are also possible, as will be appreciated by the person skilled in the art.

The layout of the conductor circuit matches substantially the layout of the electrical contacts 12, 13 on the rear surface 11 of the back-contacted solar cells 10 and with the arrangement of the solar cells 10 next to each other.

In figure 1b the locations where the conductor circuit is to be in electrical contact with the electrical contacts 12; 13 of the at least one back-contacted solar cell 10 are indicated by crosses 28.

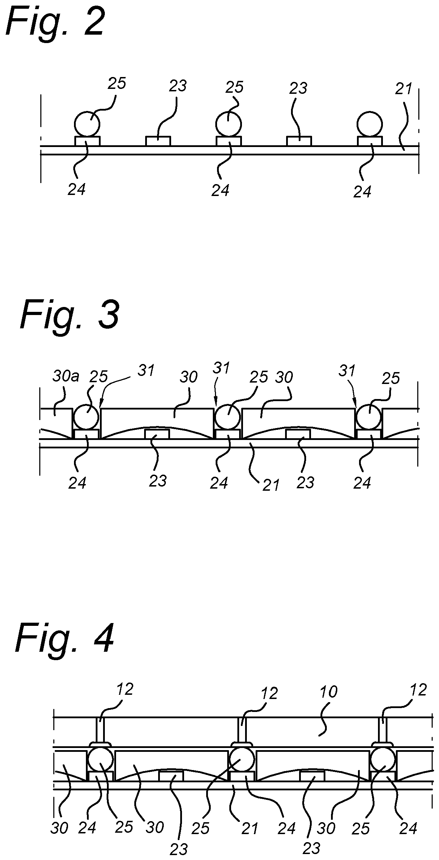

Figure 2 shows a cross-section of the back-contacted solar panel during a first manufacturing step.

The cross-section of figure 2 corresponds with line II - II in figure 1b.

On the polymer layer 21 of the back sheet contact layer 20, the patterned conductive areas 24, 23 are arranged. In this example, the conductive areas with reference 24 are interconnected and should connect to electrical contacts of one polarity on the at least one back-contacted solar cell 10. Therefore, interconnecting bodies 25 are put on the conductive areas 24 for providing (at later stage of the manufacturing process) electrical connection between the conductive areas 24 of the conductor circuit and the electrical contact 13 of the back-contacted solar cell(s) 10.

The interconnecting bodies 25 may be embodied as dots of a conductive adhesive or dots of a conductive polymer or dots of a hybrid material containing solder and a polymer, as preforms of a conductive polymer or preforms of a hybrid material containing solder and a polymer, as parts cut or stamped from a conductive tape.

In an embodiment, the material of the interconnecting bodies is stencil printed on the back-sheet contact layer by depositing a dot of the material at each of the locations corresponding to the electrical contacts of the one or more solar cells. The shape and size of the dot is predetermined by the thickness of the stencil and the size of the interconnecting body to be formed. The height of the dot is typically at least 125% of the thickness of the encapsulant layer used (see below).

In a similar way, interconnecting bodies 25 will be put on the other conductive area 23 at locations corresponding with locations of the electrical contacts 12 of the opposite polarity on the rear surface 11 of the back-contacted solar cell(s).

In an embodiment, the material of the interconnecting body is a conductive adhesive.

In a further embodiment, the conductive adhesive is a composite with a matrix material based on a polymer selected from a group of epoxy, silicone, acrylate and hybrid polymers and comprises a conductive component.

In an embodiment, the conductive adhesive comprises metal particles forming a conductive path as the conductive component.

Alternatively, the conductive adhesive comprises low temperature solder as the conductive component that forms a conductive path through the interconnecting body.

Figure 3 shows a cross-section of the back-contacted solar panel during a subsequent manufacturing step.

In a subsequent manufacturing step, a first encapsulant layer 30 will be arranged over the arrangement of the back sheet contact layer 20 and the interconnecting bodies 25 positioned thereon. This first encapsulant layer will serve as an insulating layer between the conductor circuit and the rear surface of the solar cell(s). Also, the first encapsulant layer will serve as a sealing layer to protect the solar cells from moisture etc.

The first encapsulant layer 30 is provided with a plurality of openings 31 that correspond with the locations of the interconnecting bodies 25 and the locations of the electrical contacts on the rear surface of the back-contacted solar cell.

The first encapsulant layer has such a thickness that the interconnecting bodies 25 protrude above the top surface 30a of the encapsulant layer 30.

In an embodiment, the first encapsulant layer comprises a polymer preferably a thermoplastic polymer. In an embodiment, the first encapsulant layer comprises a polymer selected from a group comprising ethylene-vinyl-acetate, ionomers, silicone based encapsulants, TPU (thermoplastic urethane), PVB (polyvinyl butyral).

Figure 4 shows a cross-section of the back-contacted solar panel during a next manufacturing step.

In this manufacturing step, the back-contacted solar cell(s) are positioned on top of the interconnecting bodies and the top surface of the first encapsulant layer. The electrical contacts 12, 13 on the rear surface of each solar cell 10 are positioned at the locations of the corresponding protruding interconnecting bodies 25.

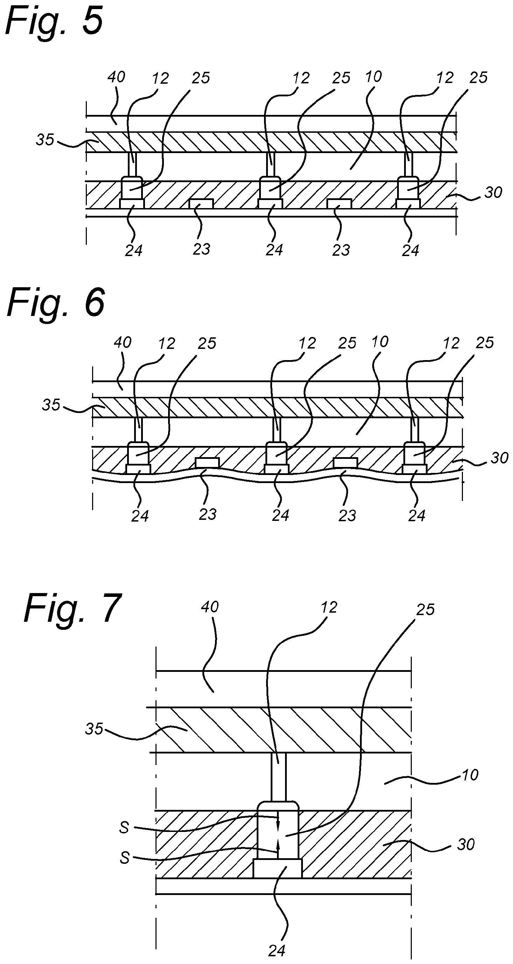

Figure 5 shows a cross-section of the back-contacted solar panel during yet a further manufacturing step.

During this manufacturing step, a second encapsulant layer 35 is positioned over the front surfaces of the solar cells 10. The second encapsulant layer serves the purpose to electrically insulate the solar cells, to provide an elastic layer for accommodating the solar cells on the glass plate (see below) and to seal them from harmful substances such as moisture.

In an embodiment, the second encapsulant layer comprises a thermoplastic polymer. In an embodiment, the second encapsulant layer comprises a polymer selected from a group comprising ethylene-vinyl-acetate, ionomers, (poly) silicone based encapsulants, TPU, and PVB.

After placing the second encapsulant layer, a glass plate 40 is arranged on top of the second encapsulant layer 35.

After these steps, the solar panel comprises a stacked structure of the back sheet contact layer 20 with a conductor circuit 21, the first encapsulant layer 30 with interconnecting bodies 25 in openings of the first encapsulant layer, the solar cell(s) 10, the second encapsulant layer 35 and the glass plate 40.

The stacked structure may be inverted so that during processing of the panel, the glass sheet is on the bottom of the stack.

Subsequently, the stacked structure is exposed to elevated temperature and elevated pressure during a lamination process. Such lamination process takes place in a laminator device (not shown), curing both the encapsulant layers and the interconnecting body material so as to form a continuous laminate.

During the combined lamination and interconnection step in module manufacturing using back-contact cells with a conductive back-sheet and interconnection paste, the interaction of the various materials i.e., the encapsulant material and the material of the interconnection, is critical in obtaining a compressive stress to reinforce the interconnection.

The temperature profile of the combined lamination and interconnection step is divided into three stages. The first stage heats the laminate from room temperature to approximately 150°C over a period of approximately 5 minutes. During the first part of this stage, the double vacuum chamber above the laminate is evacuated. When the temperature is above approximately 80°C, pressure is applied to the laminate by allowing the top chamber of the laminator to return to atmospheric pressure. In the second stage, the laminate is held at 150°C with the vacuum in the lower chamber being maintained for a period of approximately 15 minutes. The final stage comprises the steps to break the vacuum, remove the laminate from the laminator and to allow it to cool to room temperature.

During the first stage, the interconnection dot (or paste) must either start to cure or be able to maintain its height as determined by the printing step.

Preferably, the interconnecting material has been cured or starts curing before the flow and shrinkage of the encapsulant material(s) takes place. In an embodiment, an onset temperature for the curing of the interconnecting material is lower than an onset temperature for the flow of the encapsulant material. In this manner, the interconnecting material has started to cure fully or to large extent, when the flow of the encapsulant material takes place, thus providing mechanical strength to the interconnecting body during the flow of the encapsulant material.

During the second stage, the encapsulant material will melt and flow to fill any cavities in the module. Adhesion between the back-sheet foil and the encapsulant material and between the glass and encapsulant material is established during this stage. Adhesion between the back-sheet and the encapsulant material will pull the back-sheet towards the other materials making up the laminate. As the interconnection material can maintain its height at this stage, it will not move with the back-sheet, but will resist its movement, resulting in a compressive stress on the interconnection. The interconnection bodies material will either reach complete cure during the second stage or will not show any deformation, but at the same time will be capable of forming an adhesive bond with and electric contact between the electrical contacts of the cells and the contact area of the conductive back-sheet. At the end of this stage, the laminate will have reached a steady state with good adhesion between all relevant surfaces and a stable electrical contact between the cells and the conductive back-sheet.

During lamination including the cooling step afterwards, the encapsulant layers 30 (and the back-sheet contact layer) shrink to some extent in a direction perpendicular to the interface between the respective encapsulant layer and the surface of the solar cell.

During the final stage of lamination, the laminate will cool to room temperature.

According to an aspect of the invention, the coefficient of thermal expansion of the first encapsulant is typically 4 to 5 times higher than that of the conductive adhesive. This implies that the change in height of the encapsulant (i.e. perpendicular to its interface with solar cell) and will be greater than the change in height of the conductive adhesive in the same direction. This difference in change in height will result in an extra compressive stress being imposed on the conductive adhesive by the conductive back-sheet which has become attached to the encapsulant during the encapsulation process.

Thus, according to the invention a combination of interconnecting material and encapsulant material is selected that produces after the lamination process and cooling a compressive stress in the interconnecting material.

In the solar panel in a direction perpendicular to an interface of the solar cell and the first encapsulant layer, the interconnecting bodies are under a compressive stress.

The compressive stress may be due to the occurrence of a difference in volume of the respective layers during the lamination process, with a volume of the encapsulant material being relatively smaller than the volume of the interconnecting material after the lamination process.

The difference in volume may be brought about by either chemical or physical effects (a chemical reaction or a change of density for example) in the respective layer.

In an embodiment, the volume of the interconnecting body is selected to be larger than the volume of the encapsulant layer, without taking into account an thermal effects: the dots that are stencil printed are protruding from the openings in the encapsulant layer, i.e., are relatively oversized and have a height larger than the thickness of the encapsulant layer. During lamination the back-sheet layer and the encapsulant layer are made to press on the interconnecting body material due to the volume difference, causing a compressive stress in the interconnecting bodies.

Additionally or alternatively, the combination of interconnecting material and encapsulant material is selected such that due to the lamination process the interconnecting material shrinks relatively less than the encapsulant layer material, which has also the effect that the interconnecting bodies are pressed between the solar cell surface and the encapsulant layer and are in a state of compressive stress. The method can apply only the shrinkage effect but may combine this shrinkage effect with the effect caused by the oversize effect.

Additionally or alternatively, the combination of interconnecting material and encapsulant material is selected such that the interconnecting body material has a relatively smaller thermal expansion coefficient than the thermal expansion coefficient of the encapsulant material. Again, this has the effect that due to the lamination process the interconnecting material shows a thermal shrinkage that is relatively less than the thermal shrinkage of the encapsulant layer material. This has also the effect that the interconnecting bodies are pressed between the solar cell surface and the encapsulant layer and are in a state of compressive stress. The method can apply only the thermal shrinkage effect but may combine this thermal shrinkage effect with the effect caused by either the shrinkage effect or the oversize effect, or their combination.

It has been found that if the interconnection body material 25 does not shrink or shrinks less than the encapsulant layer material during the combined lamination and interconnection step, the interconnecting bodies will be exposed to a compressive force by the surrounding encapsulant layer material. If the material of the interconnecting bodies is strong enough to withstand the compressive force imposed on it by the back-sheet and encapsulant, the interconnecting bodies are able to form a good and reliable interconnection in a back-contact module.

The shrinkage of the encapsulant layers is resisted by the glass sheet, so causing the encapsulant and back-sheet contact layers to impose a compressive force on the interconnecting bodies between the conductor circuit on the back-sheet contact layer and the rear surface of the solar cells.

In doing this, the interconnection does not rely solely on the adhesive strength of the interconnection material with the cell contact pad and the conductive back-sheet, but is reinforced by a compressive force imposed by the encapsulant and back-sheet.

Thus according to the invention, a solar panel is provided with a stack comprising at least one solar cell, a first encapsulant layer and a back-sheet contact layer; the at least one solar cell being arranged as a back contacted solar cell with a front surface for receiving radiation and a rear surface provided with electrical contacts; the back contact sheet layer having a surface provided with a patterned conductor circuit, the conductor circuit being arranged with contacting areas located at locations corresponding to locations of the electrical contacts on the at least one solar cell; the first encapsulant layer being provided with a pattern of openings at locations corresponding to the locations of the electrical contacts on the at least one solar cell; the at least one solar cell being arranged on top of the first encapsulant layer; the first encapsulant layer being arranged on top of the back-sheet contact layer, with the rear surface of the at least one solar cell facing the patterned conductor circuit surface, such that the first encapsulant layer is between the at least one solar cell and the back-sheet contact layer; the locations of the electrical contacts, the openings in the first encapsulant layer and the contacting areas being aligned with each other; each electrical contact of the at least one solar cell being connected through a corresponding opening in the first encapsulant layer with a respective corresponding contacting area of the conductor circuit by an interconnecting body; wherein in a direction perpendicular to an interface of the solar cell and the first encapsulant layer, the interconnecting body is under a compressive stress.

Figure 6 shows a cross-section of a solar panel according to the invention, wherein the compression of the interconnecting bodies is observable by bulges in the back-sheet contact layer at locations corresponding with the locations of the interconnecting bodies in the solar panel.

Figure 7 shows a detail of the cross-section of a solar panel according to the invention.

In this detailed cross-section the compressive force exerted on the interconnecting body 25 due to the relatively shrunk encapsulant layer material is denoted by the arrows S.

The compressive force indicates that the interconnecting body is in fact pressed between the interfaces with the electrical contact 12; 13 and the contacting area of the conductor circuit, respectively. The pressure on the interfaces ensures that a good contact is maintained.

The compressive force on the interconnecting body may be balanced by a tensile force on the shrunk encapsulant layers.

The shrinkage of the encapsulant layer material and of the interconnecting body material can be of a chemical or physical nature, e.g., a change of composition, or density, or difference in thermal expansion or flow between the respective materials.

Therefore, shrinkage is defined here as an effective change of volume of the respective material.

In an embodiment, the material of the interconnecting body has a smaller overall shrinkage than an overall shrinkage of the material of the first encapsulant layer during the lamination process.

Alternatively or additionally, where the shrinkage would be governed by thermal expansion phenomena, the material of the interconnecting body has a smaller thermal shrinkage than a thermal shrinkage of a material of the first encapsulant layer in a temperature interval from a lamination temperature to about room temperature.

The lamination temperature could be a temperature in a range between about 150 and about 100 °C.

In an embodiment, the manufacturing steps can be defined by a method for manufacturing a solar panel comprising a stack of at least one solar cell, a back-sheet contact layer and a first encapsulant layer, comprising the steps of:
-- providing a back contacted solar cell with a front surface for receiving radiation and a rear surface provided with electrical contacts as the at least one solar cell;
-- providing the back-sheet contact layer with a patterned conductor circuit on a surface thereof, the conductor circuit being arranged with contacting areas located at locations corresponding to locations of the electrical contacts on the at least one solar cell;
-- providing at each contacting area an interconnecting body;
-- providing the first encapsulant layer with a pattern of openings at locations corresponding to the locations of the electrical contacts on the at least one solar cell;
-- arranging the patterned first encapsulant layer on top of the back-sheet contact layer with the pattern of openings aligned over the locations of the electrical contacts in such a way that each interconnecting body is located in the corresponding opening in the first encapsulant layer;
-- arranging the at least one solar cell on top of the patterned first encapsulant layer with the rear surface of the at least one solar cell facing the patterned conductor circuit surface, and each of the electrical contacts of the at least one solar cell faces the corresponding interconnection body through the first encapsulant layer;
-- connecting each electrical contact of the at least one solar cell with a respective corresponding contact area of the conductor circuit by the corresponding interconnecting body;
wherein after a lamination process of the stack, in a direction perpendicular to an interface of the solar cell and the first encapsulant layer, the interconnecting body is under a compressive stress.

It will be apparent to the person skilled in the art that other embodiments of the invention can be conceived and reduced to practice without departing from the scope of the invention, the scope of the invention being limited only by the appended claims as finally granted. The description of embodiments above is not intended to limit the scope of the invention.

## Claims

1. Solar panel provided with a stack comprising at least one solar cell (10), a first encapsulant layer (30) and a back-sheet contact layer (20); the at least one solar cell being arranged as a back contacted solar cell with a front surface for receiving radiation and a rear surface (11) provided with electrical contacts (12, 13); the back contact sheet layer having a surface provided with a patterned conductor circuit (21), the conductor circuit being arranged with contacting areas (22, 23, 24) located at locations corresponding to locations of the electrical contacts on the at least one solar cell;
the first encapsulant layer being provided with a pattern of openings at locations corresponding to the locations of the electrical contacts on the at least one solar cell;
the at least one solar cell being arranged on top of the first encapsulant layer;
the first encapsulant layer being arranged on top of the back-sheet contact layer, with the rear surface of the at least one solar cell facing the patterned conductor circuit surface, such that the first encapsulant layer is between the at least one solar cell and the back-sheet contact layer;
the locations of the electrical contacts, the openings in the first encapsulant layer and the contacting areas being aligned with each other;
each electrical contact of the at least one solar cell being connected through a corresponding opening in the first encapsulant layer with a respective corresponding contacting area of the conductor circuit by an interconnecting body (25), the interconnecting body being arranged in the opening in the first encapsulant layer;
wherein
the material of the interconnecting body is a conductive adhesive; **characterized in that** the material of the interconnecting body has a smaller thermal shrinkage than a thermal shrinkage of a material of the first encapsulant layer during lamination in a temperature interval from an elevated lamination temperature to about room temperature;
and
the interconnecting body when it has been cured, is compressed between the contacting area and the corresponding electrical contact in such a way that in a direction perpendicular to an interface of the solar cell and the first encapsulant layer, the interconnecting body is pre-stressed under a compressive stress.

2. Solar panel according to claim 1 wherein a material of the interconnecting body (25) has a smaller overall shrinkage than an overall shrinkage of a material of the first encapsulant layer (30) during the lamination process.

3. Solar panel according to claim 1, wherein the material of the interconnecting body (25) has an effective thermal expansion coefficient smaller that the effective thermal expansion coefficient of the material of the first encapsulant layer (30) in said temperature interval.

4. Solar panel according to claim 1, wherein the material of the interconnecting body (25) has a smaller thermal shrinkage than the thermal shrinkage of the material of the back-sheet contact layer (20) in said temperature interval.

5. Solar panel according to claim 1, wherein the thermal shrinkage is determined substantially perpendicular to the interface of the first encapsulant layer (30) and the solar cell (10).

6. Solar panel according to claim 5, wherein the conductive adhesive is a composite with a matrix material based on a polymer selected from a group of epoxy, acrylate, and silicone, and comprising a conductive component.

7. Solar panel according to claim 1 or 5, wherein the conductive adhesive comprises metal particles forming a conductive path as the conductive component.

8. Solar panel according to claim 1 or claim 5 or claim 6, wherein the conductive adhesive comprises as the conductive component a conductive path consisting of low temperature solder.

9. Solar panel according to any one of the preceding claims, wherein the solar panel further comprises a second encapsulant layer (35) and a glass plate (40); the second encapsulant layer being arranged on top of the front surface of the at least one solar cell (10), and the glass plate being on top of the second encapsulant layer, the second encapsulant layer thus being between the at least one solar cell and the glass plate.

10. Solar panel according to any one of the preceding claims, wherein the first and/or second encapsulant layer (30, 35) comprises a polymer selected from a group comprising ethylene-vinyl-acetate, ionomers, (poly)silicone, thermoplastic urethane, and polyvinyl butyral.

11. Solar panel according to any one of the preceding claims wherein the at least one solar cell (10) is a silicon based back-contacted solar cell.

12. Solar panel according to any one of the preceding claims, wherein in the back-sheet contact layer (20) bulges are observable at locations corresponding with the locations of the interconnecting bodies (25) in the solar panel.

13. Method for manufacturing a solar panel provided with a stack comprising at least one solar cell (10), a back-sheet contact layer (20) and a first encapsulant layer (30), comprising the steps of:
-- providing one or more back contacted solar cells with a front surface for receiving radiation and a rear surface (11) provided with electrical contacts (12, 13) as the at least one solar cell;
-- providing the back-sheet contact layer with a patterned conductor circuit (21) on a surface thereof, the conductor circuit being arranged with contacting areas (22, 23, 24) located at locations corresponding to locations of the electrical contacts on the at least one solar cell;
-- providing at each contacting area an interconnecting body (25);
-- providing the first encapsulant layer with a pattern of openings at locations corresponding to the locations of the electrical contacts on the at least one solar cell;
-- arranging the patterned first encapsulant layer on top of the back-sheet contact layer, the pattern of openings being aligned with the locations of the electrical contacts in such a way that each interconnecting body is located in the corresponding opening in the first encapsulant layer;
-- arranging the at least one solar cell on top of the patterned first encapsulant layer with the rear surface of the at least one solar cell facing the patterned conductor circuit surface, and each of the electrical contacts of the at least one solar cell faces the corresponding interconnection body through the first encapsulant layer;
-- connecting each electrical contact of the at least one solar cell with a respective corresponding contacting area of the conductor circuit by the corresponding interconnecting body in the respective corresponding opening in the first encapsulant layer;
-- creating during a lamination step a compressive stress in the interconnecting body in a direction perpendicular to an interface between the at least one solar cell and the first encapsulant layer,
wherein the material of the interconnecting body is a conductive adhesive;
wherein the material of the interconnecting body has a smaller thermal shrinkage than a thermal shrinkage of a material of the first encapsulant layer during lamination in a temperature interval from an elevated lamination temperature to about room temperature;
wherein after the lamination process of the stack, the interconnecting body is compressed between the contacting area and the corresponding electrical contact in such a way that in a direction perpendicular to an interface of the solar cell and the first encapsulant layer, the interconnecting body is pre-stressed under a compressive stress.

14. Method according to claim 13 wherein the material of the interconnecting body (25) has a smaller overall shrinkage than an overall shrinkage of the material of the first encapsulant layer (30) during the lamination process.

15. Method according to claim 13 wherein each interconnecting body (25) is formed as a dot on the corresponding contacting area of the conductor circuit (21) by stencil printing preceding the step of arranging the patterned first encapsulant layer (30) on top of the back-sheet contact layer.

16. Method according to claim 15, wherein the formation of the dot includes that the formed dot has a height substantially larger than a thickness of the patterned first encapsulant layer (30).

17. Method according to claim 15 or 16, wherein the at least one solar cell (10) is arranged on the patterned first encapsulant layer (30) after formation of the interconnecting body dots on the contacting areas of the conductor circuit (21).

18. Method according to any one of claims 13 - 17 , wherein the material of the interconnecting body (25) is a conductive adhesive and said step of connecting each electrical contact of the at least one solar cell with a respective corresponding contacting area of the conductor circuit comprises a curing heat treatment of the interconnecting body dot to form the interconnecting body.

19. Method according to any one of preceding claims 13 - 18, further comprising:
-- providing a second encapsulant layer (35) over the front surface of the at least one solar cell;
-- providing a glass plate (40) over the second encapsulant layer;
-- laminating the stack comprising the back-sheet contact layer (20), the first encapsulant layer (30), the at least one solar cell (10), the second encapsulant layer and the glass plate by exposure to an elevated temperature and an elevated pressure to form the solar panel.

20. Method according to claim 19, wherein the curing heat treatment of the interconnecting body dots takes place during said lamination step.

21. Method according to claim 19 or 20, wherein before said lamination step the first encapsulant layer (30) has a thickness smaller than a height of the interconnection body (25).

## Patentansprüche

1. Solarmodul mit einem Stapel umfassend
mindestens eine Solarzelle (10), eine erste Verkapselungsschicht (30) und eine Rückseiten-Kontaktschicht (20);
wobei die mindestens eine Solarzelle als rückseitig kontaktierte Solarzelle mit einer Vorderfläche zur Aufnahme von Strahlung und einer mit elektrischen Kontakten (12, 13) versehenen Rückfläche (11) ausgestaltet ist;
wobei die Rückseiten-Kontaktschicht eine Oberfläche aufweist, die mit einer strukturierten Leiterschaltung (21) versehen ist, wobei die Leiterschaltung mit Kontaktbereichen (22, 23, 24) ausgestaltet ist, die an Stellen angeordnet sind, die Stellen der elektrischen Kontakte auf der mindestens einen Solarzelle entsprechen;
wobei die erste Verkapselungsschicht mit einem Muster von Öffnungen an Stellen versehen ist, die den Stellen der elektrischen Kontakte auf der mindestens einen Solarzelle entsprechen;
wobei die mindestens eine Solarzelle auf der ersten Verkapselungsschicht angeordnet ist; wobei die erste Verkapselungsschicht auf der Rückseiten-Kontaktschicht angeordnet ist, wobei die Rückfläche der mindestens einen Solarzelle der Oberfläche des strukturierten Leiterschaltkreises zugewandt ist, so dass die erste Verkapselungsschicht zwischen der mindestens einen Solarzelle und der Rückseiten-Kontaktschicht liegt;
wobei die Stellen der elektrischen Kontakte, der Öffnungen in der ersten Verkapselungsschicht und der Kontaktbereiche zueinander ausgerichtet sind;
wobei jeder elektrische Kontakt der wenigstens einen Solarzelle durch eine entsprechende Öffnung in der ersten Verkapselungsschicht mit einer jeweiligen entsprechenden Kontaktfläche der Leiterschaltung durch einen Verbindungskörper (25) verbunden ist, wobei der Verbindungskörper in der Öffnung in der ersten Verkapselungsschicht angeordnet ist;
wobei das Material des Verbindungskörpers ein leitfähiger Klebstoff ist,
**dadurch gekennzeichnet, dass**
das Material des Verbindungskörpers eine geringere thermische Schrumpfung aufweist als eine thermische Schrumpfung eines Materials der ersten Verkapselungsschicht während der Laminierung in einem Temperaturintervall von einer erhöhten Laminierungstemperatur bis etwa Raumtemperatur; und
der Verbindungskörper in einem ausgehärteten Zustand zwischen dem Kontaktbereich und dem entsprechenden elektrischen Kontakt derart komprimiert wird, dass in einer Richtung senkrecht zu einer Grenzfläche der Solarzelle und der ersten Verkapselungsschicht der Verbindungskörper unter einer Druckspannung vorgespannt ist.

2. Solarmodul nach Anspruch 1, wobei ein Material des Verbindungskörpers (25) eine geringere Gesamtschrumpfung aufweist als eine Gesamtschrumpfung eines Materials der ersten Verkapselungsschicht (30) während des Laminierungsprozesses.

3. Solarmodul nach Anspruch 1, wobei das Material des Verbindungskörpers (25) einen effektiven Wärmeausdehnungskoeffizienten aufweist, der in dem Temperaturintervall kleiner als der effektive Wärmeausdehnungskoeffizient des Materials der ersten Verkapselungsschicht (30) ist.

4. Solarmodul nach Anspruch 1, wobei das Material des Verbindungskörpers (25) in dem Temperaturintervall eine geringere Wärmeschrumpfung aufweist als die Wärmeschrumpfung des Materials der Rückseiten-Kontaktschicht (20).

5. Solarmodul nach Anspruch 1, wobei die thermische Schrumpfung im Wesentlichen senkrecht zu der Grenzfläche der ersten Verkapselungsschicht (30) und der Solarzelle (10) bestimmt ist.

6. Solarmodul nach Anspruch 5, wobei der leitfähige Klebstoff ein Verbundstoff mit einem Matrixmaterial basierend auf einem Polymer ausgewählt aus einer Gruppe von Epoxid, Acrylat und Silikon ist, sowie eine leitfähige Komponente umfasst.

7. Solarmodul nach Anspruch 1 oder 5, wobei der leitfähige Klebstoff Metallpartikel umfasst, die einen leitfähigen Pfad als leitfähige Komponente bilden.

8. Solarmodul nach Anspruch 1 oder Anspruch 5 oder Anspruch 6, wobei der leitfähige Klebstoff als leitfähige Komponente einen leitfähigen Pfad aufweist, der aus einem Niedertemperaturlot besteht.

9. Solarmodul nach einem der vorhergehenden Ansprüche, wobei das Solarmodul ferner eine zweite Verkapselungsschicht (35) und eine Glasplatte (40) umfasst; wobei die zweite Verkapselungsschicht auf der Vorderfläche der mindestens einen Solarzelle (10) angeordnet ist und die Glasplatte auf der zweiten Verkapselungsschicht liegt, so dass die zweite Verkapselungsschicht zwischen der mindestens einen Solarzelle und der Glasplatte liegt.

10. Solarmodul nach einem der vorhergehenden Ansprüche, wobei die erste und/oder zweite Verkapselungsschicht (30, 35) ein Polymer umfasst ausgewählt aus einer Gruppe umfassend Ethylen-Vinylacetate, Ionomere, (Poly)-Silikone, thermoplastische Urethane und Polyvinylbutyrale.

11. Solarmodul nach einem der vorhergehenden Ansprüche, wobei die mindestens eine Solarzelle (10) eine rückkontaktierte Solarzelle auf Siliziumbasis ist.

12. Solarmodul nach einem der vorhergehenden Ansprüche, wobei in der Rückseiten-Kontaktschicht (20) Auswölbungen an Stellen beobachtbar sind, die den Stellen der Verbindungskörper (25) in dem Solarmodul entsprechen.

13. Verfahren zur Herstellung eines Solarmoduls mit einem Stapel umfassend mindestens eine Solarzelle (10), eine erste Verkapselungsschicht (30) und eine Rückseiten-Kontaktschicht, umfassend die Schritte:
- Bereitstellen einer oder mehrerer rückseitenkontaktierter Solarzellen mit einer Vorderfläche zum Empfangen von Strahlung und einer Rückfläche (11) mit elektrischen Kontakten (12, 13) als die mindestens eine Solarzelle;
- Vorsehen der Rückseiten-Kontaktschicht mit einer strukturierten Leiterschaltung (21) auf einer Oberfläche davon, wobei die Leiterschaltung mit Kontaktbereichen (22, 23, 24) an Stellen versehen ist, die den Stellen der elektrischen Kontakte auf der mindestens einen Solarzelle entsprechen;
- Bereitstellen eines Verbindungskörpers (25) in jedem Kontaktbereich;
- Vorsehen der ersten Verkapselungsschicht mit einem Muster von Öffnungen an Stellen, die den Stellen der elektrischen Kontakte auf der mindestens einen Solarzelle entsprechen;
- Anordnen der strukturierten ersten Verkapselungsschicht auf der Rückseiten-Kontaktschicht, wobei das Muster der Öffnungen mit den Stellen der elektrischen Kontakte derart ausgerichtet ist, dass sich jeder Verbindungskörper in der entsprechenden Öffnung in der ersten Verkapselungsschicht befindet;
- Anordnen der mindestens einen Solarzelle auf der strukturierten ersten Verkapselungsschicht, wobei die Rückfläche der mindestens einen Solarzelle der Oberfläche der strukturierten Leiterschaltung zugewandt ist und jeder der elektrischen Kontakte der mindestens einen Solarzelle dem entsprechenden Verbindungskörper durch die erste Verkapselungsschicht zugewandt ist;
- Verbinden jedes elektrischen Kontakts der mindestens einen Solarzelle mit einem jeweiligen entsprechenden Kontaktbereich des Leiterkreises durch den entsprechenden Verbindungskörper in der jeweiligen entsprechenden Öffnung der ersten Verkapselungsschicht;
- Erzeugen einer Druckspannung in dem Verbindungskörper in einer Richtung senkrecht zu einer Grenzfläche zwischen der wenigstens einen Solarzelle und der ersten Verkapselungsschicht während eines Laminierungsschritts,
wobei das Material des Verbindungskörpers ein leitfähiger Klebstoff ist,
wobei das Material des Verbindungskörpers eine geringere thermische Schrumpfung aufweist als eine thermische Schrumpfung eines Materials der ersten Verkapselungsschicht während der Laminierung in einem Temperaturintervall von einer erhöhten Laminierungstemperatur bis etwa Raumtemperatur;
wobei der Verbindungskörper zwischen dem Kontaktbereich und dem jeweiligen elektrischen Kontakt nach dem Laminierungsprozess des Stapels derart komprimiert ist, dass in einer Richtung senkrecht zu einer Grenzfläche von der Solarzelle und der ersten Verkapselungsschicht der Verbindungskörper unter einer Druckspannung vorgespannt ist.

14. Verfahren nach Anspruch 13, wobei das Material des Verbindungskörpers eine geringere Gesamtschrumpfung aufweist als eine Gesamtschrumpfung des Materials der ersten Verkapselungsschicht (30) während des Laminierungsprozesses.

15. Verfahren nach Anspruch 13, wobei jeder Verbindungskörper (25) als ein Punkt auf der entsprechenden Kontaktfläche der Leiterschaltung (21) durch Schablonendruck vor dem Schritt des Anordnens der strukturierten ersten Verkapselungsschicht (30) auf der Rückseiten-Kontaktschicht gebildet wird.

16. Verfahren nach Anspruch 15, wobei die Bildung des Punkts beinhaltet, dass der gebildete Punkt eine Höhe aufweist, die wesentlich größer als eine Dicke der strukturierten ersten Verkapselungsschicht (30) ist.

17. Verfahren nach Anspruch 15 oder 16, wobei die mindestens eine Solarzelle (10) nach Bildung der verbindenden Körperpunkte auf den Kontaktflächen der Leiterschaltung (21) auf der strukturierten ersten Verkapselungsschicht (30) angeordnet wird.

18. Verfahren nach einem der Ansprüche 13 - 17, wobei das Material des Verbindungskörpers (25) ein leitfähiger Klebstoff ist und der Schritt des Verbindens jedes elektrischen Kontakts der mindestens einen Solarzelle mit einem jeweiligen entsprechenden Kontaktbereich der Leiterschaltung eine Aushärtewärmebehandlung des Verbindungskörperpunkts zur Bildung des Verbindungskörpers umfasst.

19. Verfahren nach einem der vorhergehenden Ansprüche 13 - 18, ferner umfassend:
- Bereitstellen einer zweiten Verkapselungsschicht (35) über der Vorderfläche der mindestens einen Solarzelle;
- Bereitstellen einer Glasplatte (40) über der zweiten Verkapselungsschicht;
- Laminieren des Stapels umfassend die Rückseiten-Kontaktschicht (20), die erste Verkapselungsschicht (30), die mindestens eine Solarzelle (10), die zweite Verkapselungsschicht und die Glasplatte durch Aussetzen mit einer erhöhten Temperatur und einem erhöhten Druck, um das Solarmodul zu bilden.

20. Verfahren nach Anspruch 19, wobei die Aushärtewärmebehandlung der Punkte des Verbindungskörpers während des Laminierungsschrittes stattfindet.

21. Verfahren nach Anspruch 19 oder 20, wobei vor dem Laminierungsschritt die erste Verkapselungsschicht (30) eine Dicke aufweist, die kleiner als eine Höhe des Verbindungskörpers (25) ist.

## Revendications

1. Panneau solaire muni d'un empilement comprenant au moins une cellule solaire (10), une première couche d'encapsulation (30) et une couche de contact de feuille arrière (20) ;
la au moins une cellule solaire étant conçue sous forme d'une cellule solaire à contact arrière ayant une surface avant pour recevoir un rayonnement et une surface arrière (11) munie de contacts électriques (12, 13) ;
la couche de feuille de contact arrière ayant une surface munie d'un circuit conducteur configuré (21), le circuit conducteur étant conçu à l'aide de zones de contact (22, 23, 24) situées à des emplacements correspondant à des emplacements des contacts électriques sur la au moins une cellule solaire ;
la première couche d'encapsulation étant munie d'un motif d'ouvertures à des emplacements correspondant aux emplacements des contacts électriques sur la au moins une cellule solaire ;
la au moins une cellule solaire étant disposée sur la partie supérieure de la première couche d'encapsulation ;
la première couche d'encapsulation étant disposée sur la partie supérieure de la couche de contact de feuille arrière, la surface arrière de la au moins une cellule solaire faisant face à la surface du circuit conducteur configuré, de sorte que la première couche d'encapsulation se trouve entre la au moins une cellule solaire et la couche de contact de feuille arrière ;
les emplacements des contacts électriques, les ouvertures dans la première couche d'encapsulation et les zones de contact étant alignés les uns avec les autres ;
chaque contact électrique de la au moins une cellule solaire étant connecté à travers une ouverture correspondante dans la première couche d'encapsulation avec une zone de contact correspondante respective du circuit conducteur par un corps d'interconnexion (25), le corps d'interconnexion étant disposé dans l'ouverture de la première couche d'encapsulation ; dans lequel
le matériau du corps d'interconnexion est un adhésif conducteur ;
**caractérisé en ce que**
le matériau du corps d'interconnexion a un rétrécissement thermique plus petit qu'un rétrécissement thermique d'un matériau de la première couche d'encapsulation pendant une stratification dans un intervalle de température allant d'une température de stratification élevée à environ la température ambiante ; et
le corps d'interconnexion, lorsqu'il a été durci, est comprimé entre la zone de contact et le contact électrique correspondant de telle sorte que dans une direction perpendiculaire à une interface de la cellule solaire et de la première couche d'encapsulation, le corps d'interconnexion est précontraint sous une contrainte de compression.

2. Panneau solaire selon la revendication 1, dans lequel un matériau du corps d'interconnexion (25) a un rétrécissement global inférieur à un rétrécissement global d'un matériau de la première couche d'encapsulation (30) pendant le processus de stratification.

3. Panneau solaire selon la revendication 1, dans lequel le matériau du corps d'interconnexion (25) a un coefficient de dilatation thermique effectif inférieur au coefficient de dilatation thermique effectif du matériau de la première couche d'encapsulation (30) dans ledit intervalle de température.

4. Panneau solaire selon la revendication 1, dans lequel le matériau du corps d'interconnexion (25) a un rétrécissement thermique inférieur au rétrécissement thermique du matériau de la couche de contact de feuille arrière (20) dans ledit intervalle de température.

5. Panneau solaire selon la revendication 1, dans lequel le rétrécissement thermique est déterminé comme étant sensiblement perpendiculaire à l'interface de la première couche d'encapsulation (30) et de la cellule solaire (10).

6. Panneau solaire selon la revendication 5, dans lequel l'adhésif conducteur est un composite ayant un matériau de matrice basé sur un polymère choisi parmi un groupe d'époxy, d'acrylate et de silicone, et comprenant un composant conducteur.

7. Panneau solaire selon la revendication 1 ou 5, dans lequel l'adhésif conducteur comprend des particules métalliques formant un trajet conducteur en tant que composant conducteur.

8. Panneau solaire selon la revendication 1 ou la revendication 5 ou la revendication 6, dans lequel l'adhésif conducteur comprend en tant que composant conducteur un chemin conducteur constitué d'une soudure à basse température.

9. Panneau solaire selon l'une quelconque des revendications précédentes, dans lequel le panneau solaire comprend en outre une seconde couche d'encapsulation (35) et une plaque de verre (40) ;
la seconde couche d'encapsulation étant disposée sur la partie supérieure de la surface avant de la au moins une cellule solaire (10), et la plaque de verre étant située sur la partie supérieure de la seconde couche d'encapsulation, la seconde couche d'encapsulation se trouvant ainsi entre la au moins une cellule solaire et la plaque de verre.

10. Panneau solaire selon l'une quelconque des revendications précédentes, dans lequel la première et/ou la seconde couche d'encapsulation (30, 35) comprend un polymère choisi parmi un groupe comprenant de l'éthylène-vinyle-acétate, des ionomères, de la (poly)silicone, de l'uréthane thermoplastique et du polyvinylbutyral.

11. Panneau solaire selon l'une quelconque des revendications précédentes, dans lequel la au moins une cellule solaire (10) est une cellule solaire à contact arrière à base de silicium.

12. Panneau solaire selon l'une quelconque des revendications précédentes, dans lequel dans la couche de contact de feuille arrière (20), des renflements peuvent être observés à des emplacements correspondant aux emplacements des corps d'interconnexion (25) dans le panneau solaire.

13. Méthode de fabrication d'un panneau solaire muni d'un empilement comprenant au moins une cellule solaire (10), une couche de contact de feuille arrière (20) et une première couche d'encapsulation (30), comprenant les étapes consistant à :
- fournir une ou plusieurs cellules solaires à contact arrière ayant une surface avant pour recevoir un rayonnement et une surface arrière (11) munie de contacts électriques (12, 13) en tant que la au moins une cellule solaire ;
- fournir la couche de contact de feuille arrière ayant un circuit conducteur configuré (21) sur une surface de celle-ci, le circuit conducteur étant conçu à l'aide de zones de contact (22, 23, 24) situées à des emplacements correspondant à des emplacements des contacts électriques sur la au moins une cellule solaire ;
- fournir au niveau de chaque zone de contact un corps d'interconnexion (25) ;
- fournir la première couche d'encapsulation ayant un motif d'ouvertures à des emplacements correspondant aux emplacements des contacts électriques sur la au moins une cellule solaire ;
- agencer la première couche d'encapsulation configurée sur la partie supérieure de la couche de contact de feuille arrière, le motif d'ouvertures étant aligné avec les emplacements des contacts électriques de telle sorte que chaque corps d'interconnexion est situé dans l'ouverture correspondante dans la première couche d'encapsulation ;
- agencer la au moins une cellule solaire sur la partie supérieure de la première couche d'encapsulation configurée, la surface arrière de la au moins une cellule solaire faisant face à la surface du circuit conducteur configuré, et chacun des contacts électriques de la au moins une cellule solaire fait face au corps d'interconnexion correspondant à travers la première couche d'encapsulation ;
- connecter chaque contact électrique de la au moins une cellule solaire avec une zone de contact correspondante respective du circuit conducteur par le corps d'interconnexion correspondant dans l'ouverture correspondante respective dans la première couche d'encapsulation ;
- créer pendant une étape de stratification une contrainte de compression dans le corps d'interconnexion dans une direction perpendiculaire à une interface entre la au moins une cellule solaire et la première couche d'encapsulation,
dans laquelle le matériau du corps d'interconnexion est un adhésif conducteur ;
dans laquelle le matériau du corps d'interconnexion a un rétrécissement thermique inférieur à un rétrécissement thermique d'un matériau de la première couche d'encapsulation pendant la stratification dans un intervalle de température allant d'une température de stratification élevée à environ la température ambiante ;
dans laquelle après le processus de stratification de l'empilement, le corps d'interconnexion est comprimé entre la zone de contact et le contact électrique correspondant de telle sorte que dans une direction perpendiculaire à une interface de la cellule solaire et de la première couche d'encapsulation, le corps d'interconnexion est précontraint sous une contrainte de compression.

14. Méthode selon la revendication 13, dans laquelle le matériau du corps d'interconnexion (25) a un rétrécissement global inférieur à un rétrécissement global du matériau de la première couche d'encapsulation (30) pendant le processus de stratification.

15. Méthode selon la revendication 13, dans laquelle chaque corps d'interconnexion (25) est formé sous forme d'un point sur la zone de contact correspondante du circuit conducteur (21) par impression au pochoir avant l'étape d'agencement de la première couche d'encapsulation configurée (30) sur la partie supérieure de la couche de contact de feuille arrière.

16. Méthode selon la revendication 15, dans laquelle la formation du point comprend que le point formé a une hauteur sensiblement plus grande qu'une épaisseur de la première couche d'encapsulation configurée (30).

17. Méthode selon la revendication 15 ou 16, dans laquelle la au moins une cellule solaire (10) est disposée sur la première couche d'encapsulation configurée (30) après la formation des points de corps d'interconnexion sur les zones de contact du circuit conducteur (21).

18. Méthode selon l'une quelconque des revendications 13-17, dans laquelle le matériau du corps d'interconnexion (25) est un adhésif conducteur et ladite étape de connexion de chaque contact électrique de la au moins une cellule solaire avec une zone de contact correspondante respective du circuit conducteur comprend un traitement thermique de durcissement du point de corps d'interconnexion pour former le corps d'interconnexion.

19. Méthode selon l'une quelconque des revendications précédentes 13-18, comprenant en outre :
- fournir une seconde couche d'encapsulation (35) sur la surface avant de la au moins une cellule solaire ;
- fournir une plaque de verre (40) sur la seconde couche d'encapsulation ;
- stratifier l'empilement comprenant la couche de contact de feuille arrière (20), la première couche d'encapsulation (30), la au moins une cellule solaire (10), la seconde couche d'encapsulation et la plaque de verre par exposition à une température élevée et à une pression élevée pour former le panneau solaire.

20. Méthode selon la revendication 19, dans laquelle le traitement thermique de durcissement des points de corps d'interconnexion a lieu pendant ladite étape de stratification.

21. Méthode selon la revendication 19 ou 20, dans laquelle, avant ladite étape de stratification, la première couche d'encapsulation (30) a une épaisseur inférieure à une hauteur du corps d'interconnexion (25).
